(19)

Europäisches
Patentamt
European
Patent Office
Office européen
des brevets

(11) **EP 3 527 309 A1**

(12) **EUROPEAN PATENT APPLICATION**
published in accordance with Art. 153(4) EPC

(43) Date of publication:
**21.08.2019 Bulletin 2019/34**

(21) Application number: **17860696.8**

(22) Date of filing: **20.09.2017**

(51) Int Cl.:
**B23B 27/14** (2006.01)   **B23B 51/00** (2006.01)
**B23C 5/16** (2006.01)    **B23D 77/00** (2006.01)
**B23F 21/00** (2006.01)   **B23G 5/06** (2006.01)
**C23C 14/06** (2006.01)   **C23C 16/34** (2006.01)

(86) International application number:
**PCT/JP2017/033962**

(87) International publication number:
**WO 2018/070195 (19.04.2018 Gazette 2018/16)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **11.10.2016 JP 2016199966**

(71) Applicant: **Sumitomo Electric Hardmetal Corp.
Itami-shi, Hyogo 664-0016 (JP)**

(72) Inventors:
• **SETOYAMA, Makoto
  Itami-shi
  Hyogo 664-0016 (JP)**

• **TSUKIHARA, Nozomi
  Itami-shi
  Hyogo 664-0016 (JP)**
• **TSUTSUMIUCHI, Yuki
  Itami-shi
  Hyogo 664-0016 (JP)**
• **KUKINO, Satoru
  Itami-shi
  Hyogo 664-0016 (JP)**
• **MATSUDA, Yusuke
  Itami-shi
  Hyogo 664-0016 (JP)**
• **MOROGUCHI, Hironari
  Itami-shi
  Hyogo 664-0016 (JP)**

(74) Representative: **Boult Wade Tennant LLP
Salisbury Square House
8, Salisbury Square
London EC4Y 8AP (GB)**

(54) **SURFACE-COATED CUTTING TOOL**

(57)     A surface-coated cutting tool including a substrate including a rake face and a flank face and a coating which covers a surface of the substrate is provided. The substrate is made of a cBN sintered material or a ceramic sintered material. The coating includes an alternating layer. The alternating layer is made by alternately stacking a first layer and a second layer different in composition from the first layer. The first layer contains Al, Cr, and N. The second layer contains Ti, Al, and N. A ratio T1/T2 between a thickness T1 of the first layer and a thickness T2 of the second layer is not lower than 0.1 and lower than 1. There are thirty or more interfaces at which the first layer and the second layer are in contact with each other.

FIG.4

EP 3 527 309 A1

**Description**

TECHNICAL FIELD

The present invention relates to a surface-coated cutting tool. The present application claims priority to Japanese Patent Application No. 2016-199966 filed on October 11, 2016, the entire contents of which are herein incorporated by reference.

BACKGROUND ART

A surface-coated cutting tool in which a coating having desired characteristics is provided on a surface of a substrate made of cemented carbide, a ceramic sintered material, or a cubic boron nitride sintered material (which is also referred to as a "cBN sintered material" below) has been developed as a cutting tool.

For example, WO2015/064241 (PTL 1) discloses a surface-coated cutting tool in which a coating is provided on a surface of a substrate, the coating including an A layer and a C layer, the A layer being composed of $Ti_{1-xa}Ma_{xa}C_{1-ya}N_{ya}$ (Ma representing one or more of Cr, Nb, and W and a condition of $0 \leq xa \leq 0.7$ and $0 \leq ya \leq 1$ being satisfied), the C layer being composed of $Al_{1-(xc+yc)}Cr_{xc}Mc_{yc}N$ (Mc representing one or more of Ti, V, and Si and a condition of $0.2 \leq xc \leq 0.8$, $0 \leq yc \leq 0.6$, and $0.2 \leq xc+xy \leq 0.8$ being satisfied). According to the surface-coated cutting tool in PTL 1, a flank face wear amount Vb or finished surface roughness Rz of a work material can be reduced owing to a combined effect of a function of suppression of rake face wear and flank face wear attributed to the A layer and a function of suppression of development of boundary wear attributed to the C layer.

For example, WO2006/070730 (PTL 2) discloses a surface-coated cutting tool in which a coating is provided on a surface of a substrate, the coating including an alternating layer made by alternately stacking an A layer and a B layer, the A layer being composed of a nitride containing Al and Cr, the B layer being composed of a nitride containing Ti and Al. The coating is further configured such that a ratio $\lambda A/\lambda B$ between a thickness $\lambda A$ of the A layer and a thickness $\lambda B$ of the B layer is from 1 to 5 and the A layer is greater in thickness than the B layer. According to the surface-coated cutting tool in PTL 2, flank face wear amount Vb or finished surface roughness Rz can be reduced by alternately stacking the A layer particularly excellent in resistance to oxidation and hardness and the B layer different from the A layer in such characteristics as compressive residual stress or hardness.

CITATION LIST

PATENT LITERATURE

PTL 1: WO2015/064241
PTL 2: WO2006/070730

SUMMARY OF INVENTION

A surface-coated cutting tool according to one manner of the present disclosure includes a substrate including a rake face and a flank face and a coating which covers a surface of the substrate, the substrate being made of a cBN sintered material or a ceramic sintered material, the coating including an alternating layer, the alternating layer being made by alternately stacking a first layer and a second layer different in composition from the first layer, the first layer containing Al, Cr, and N, the second layer containing Ti, Al, and N, a ratio T1/T2 between a thickness T1 of the first layer and a thickness T2 of the second layer being not lower than 0.1 and lower than 1, and there being thirty or more interfaces at which the first layer and the second layer are in contact with each other.

A surface-coated cutting tool according to one manner of the present disclosure includes a substrate including a rake face and a flank face and a coating which covers a surface of the substrate, the substrate being made of a cBN sintered material or a ceramic sintered material, the coating including a compound layer containing Ti, Al, and N, and the compound layer having a ratio Vn/Vbmax between a boundary wear width Vn and a maximum flank face wear width Vbmax not lower than 0.2 and not higher than 0.85 (Vbmax being not smaller than 30 $\mu$m and not greater than 70 $\mu$m) when hardened steel having HRC 60 is cut at a cutting speed not lower than 150 m/min. and not higher than 200 m/min.

BRIEF DESCRIPTION OF DRAWINGS

Fig. 1 is a partial perspective view showing a form of damage to a cutting edge of a cutting tool in precision machining.
Fig. 2 is a perspective view showing one example of a surface-coated cutting tool according to one embodiment.
Fig. 3 is a cross-sectional view along the line III-III in Fig. 2.
Fig. 4 is a partial cross-sectional view when a cutting edge is honed in the surface-coated cutting tool.
Fig. 5 is a cross-sectional view schematically showing a construction of a coating according to one embodiment.

DETAILED DESCRIPTION

[Problem to be Solved by the Present Disclosure]

High working accuracy has recently been demanded in cutting. For example, in finishing a work material, such precision machining as achieving surface finish Rz of 3.2 $\mu$m or 1.6 $\mu$m has been demanded. In precision machining, when a work material is a material having a hardness around HRC 40, a cutting tool including a substrate composed of a ceramic sintered material is employed, and when a work material is a very hard material having a hardness around HRC 60, a cutting tool including a substrate composed of a cBN sintered material is employed. A lifetime of a cutting tool used for such an application is determined as having expired at the time point when prescribed surface finish can no longer be maintained. It is actually difficult for a conventional surface-coated cutting tool to maintain a sufficiently long lifetime in such precision machining.

It is an object of the present disclosure is to provide a surface-coated cutting tool having a long lifetime also in precision machining.

[Advantageous Effect of the Present Disclosure]

According to the above, a surface-coated cutting tool having a long lifetime also in precision machining can be provided.

[Description of Embodiment]

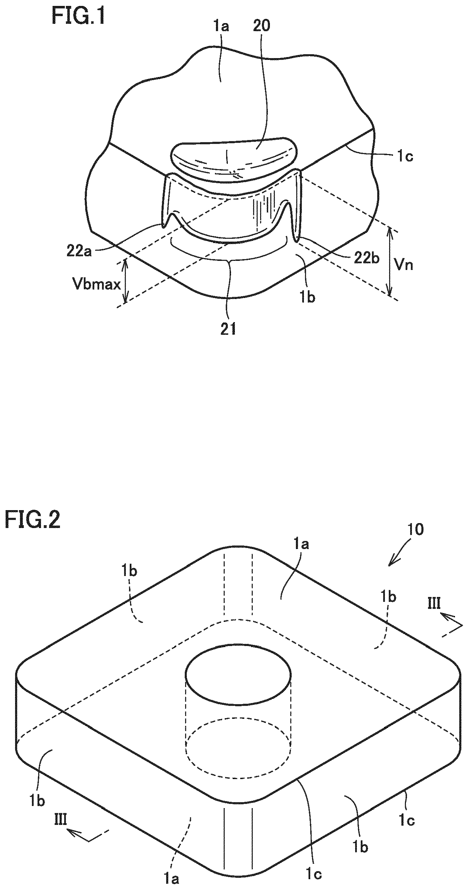

The present inventors examined a form of damage to a cutting tool in precision machining. Consequently, it was confirmed that various types of wear including crater wear (rake face wear), flank face wear, and boundary wear were caused at a cutting edge of a cutting tool. Such wear will be described below with reference to Fig. 1.

Fig. 1 shows a rake face 1a, a flank face 1b, and a cutting edge 1c of a cutting tool. In rake face 1a, a trace of wear 20 like a crater is caused by contact with chips produced from a work material. In flank face 1b, a trace of wear 21 extending in a form of a band is caused by friction with the work material. Traces of wear 22a and 22b in a form of spikes are caused at opposing ends of trace of wear 21 in a form of a band. Trace of wear 22a defines a lateral boundary portion and trace of wear 22b defines a front boundary portion.

A characteristic of high resistance against rake face wear tends to lead to a small depth of trace of wear 20, whereas a characteristic of low resistance against rake face wear tends to lead to a large depth of trace of wear 20. A width of trace of wear 21 (a distance from an original position of cutting edge 1c to a most distant position) is defined as a maximum flank face wear width Vbmax. A characteristic of high resistance against flank face wear tends to lead to small Vbmax, whereas a characteristic of low resistance against flank face wear tends to lead to large Vbmax. A width of trace of wear 22b (a distance from an original position of cutting edge 1c to a most distant position) is defined as a boundary wear width Vn. A characteristic of high resistance against boundary wear tends to lead to small Vn, whereas a characteristic of low resistance against boundary wear tends to lead to large Vn.

In general, in order to extend a lifetime of a tool in precision machining, in particular, enhancement of a characteristic of resistance against flank face wear and a characteristic of resistance against boundary wear may be required. This is because, when a characteristic of resistance against flank face wear is low, a cutting resistance increases and consequently undulation is likely in a finished surface (accuracy in working is lowered), and when a characteristic of resistance against boundary wear is low, a shape of boundary wear is transferred to a work material and consequently finished surface roughness is greater.

The present inventors attempted to extend a lifetime of a tool in precision machining by stacking a compound layer excellent in characteristic of resistance against flank face wear and a compound layer excellent in characteristic of resistance against boundary wear. Specifically, the present inventors finished hardened steel by using a surface-coated cutting tool in which a coating was provided on a surface of a substrate composed of a cBN sintered material, the coating being made by alternately stacking fifty TiAlN layers each having a thickness of 12 nm and fifty AlCrN layers each having a thickness around 48 nm. Such a coating was designed because the TiAlN layer was excellent in characteristic of resistance against flank face wear, the AlCrN layer was excellent in characteristic of resistance against boundary wear and hardness, and a super multilayered structure as above was excellent in hardness and toughness.

It was difficult, however, to continue to maintain sufficiently small finished surface roughness of a work material with this surface-coated cutting tool, and a demanded lifetime of the tool was not realized. The present inventors further elaborately examined a lifetime of a tool and a form of damage with the number of stacked compound layers and a thickness of each compound layer being intricately varied. Consequently, it was found that expected surface finish was difficult to achieve when a coating having a super multilayered structure was designed based on a characteristic exhibited by each single compound layer alone.

Then, the present inventors changed their way of thinking, and assumed that, in order to enhance characteristics in particular in connection with surface finish of a coating having a super multilayered structure, it was insufficient simply to enhance a characteristic of resistance against flank face wear and a characteristic of resistance against boundary wear, and balance between these characteristics might be important. The present inventors furthered their studies and found that finishing of hardened steel could successfully be continued by adjusting a construction of a coating for maintaining a ratio Vn/Vbmax between Vn and Vbmax within a prescribed range, and completed the present invention as a result of further studies. An embodiment of the present invention will be listed and described below.

[1] A surface-coated cutting tool according to one manner of the present invention includes a substrate including a rake face and a flank face and a coating which covers a surface of the substrate, the substrate being made of a cBN sintered material or a ceramic sintered material, the coating including an alternating layer, the alternating layer being made by alternately stacking a first layer and a second layer different in composition from the first layer, the first layer containing Al, Cr, and N, the second layer containing Ti, Al, and N, a ratio T1/T2 between a thickness T1 of the first layer and a thickness T2 of the second layer being not lower than 0.1 and lower than 1, and there being thirty or more interfaces at which the first layer and the second layer are in contact with each other.

According to the manner, a surface-coated cutting tool excellent in balance between a characteristic of resistance against flank face wear and a characteristic of resistance against boundary wear can be obtained. Therefore, the surface-coated cutting tool can have a long lifetime also in precision machining.

[2] In the cutting tool, thickness T1 and thickness T2 are each preferably not smaller than 0.5 nm and not greater than 200 nm. The alternating layer is thus better in balance above.

[3] In the cutting tool, preferably, the first layer is composed of $Al_xCr_{1-x}N$ ($0.3 \leq x \leq 0.75$) and the second layer is composed of $Ti_{1-y}Al_yN$ ($0.3 \leq y \leq 0.7$). Thus, while good balance between a characteristic of resistance against flank face wear and a characteristic of resistance against boundary wear is maintained, these characteristics can further be enhanced.

[4] In the cutting tool, the alternating layer has a thickness preferably not smaller than 0.5 $\mu$m and not greater than 20 $\mu$m. A longer lifetime can thus be achieved.

[5] A surface-coated cutting tool according to one manner of the present invention includes a substrate including a rake face and a flank face and a coating which covers a surface of the substrate, the substrate being made of a cBN sintered material or a ceramic sintered material, the coating including a compound layer containing Ti, Al, and N, and the compound layer having a ratio Vn/Vbmax between a boundary wear width Vn and a maximum flank face wear width Vbmax not lower than 0.2 and not higher than 0.85 (Vbmax being not smaller than 30 $\mu$m and not greater than 70 $\mu$m) when hardened steel having HRC 60 is cut at a cutting speed not lower than 150 m/min. and not higher than 200 m/min.

According to the manner, a surface-coated cutting tool excellent in balance between a characteristic of resistance against flank face wear and a characteristic of resistance against boundary wear can be obtained. Therefore, the surface-coated cutting tool can have a long lifetime also in precision machining.

[Details of Embodiment of the Present Invention]

One embodiment of the present invention (hereinafter denoted as the "present embodiment") will be described hereinafter, however, the present embodiment is not limited thereto. In the drawings used for description of the embodiment below, the same or corresponding elements have the same reference characters allotted. An expression in a form "A to B" herein means the upper limit and the lower limit of the range (that is, not less than A and not more than B). When a unit for A is not given and a unit is given only for B, the unit for A and the unit for B are the same. An atomic ratio not particularly identified in a chemical formula such as "AlCrN", "TiAlN", or "TiN" herein does not mean that an atomic ratio of each element is set to "1" alone but all conventionally known atomic ratios are encompassed.

<Surface-Coated Cutting Tool>

A surface-coated cutting tool in the present embodiment will be described with reference to Figs. 2 to 4. As shown in Fig. 2, a surface-coated cutting tool 10 (which is also referred to as a "tool 10" below) includes surfaces including an upper surface, a lower surface, and four side surfaces, and as a whole, it is in a shape of a quadrangular prism relatively low in vertical profile. Tool 10 is provided with a through hole which extends from the upper surface to the lower surface. In tool 10, the upper surface and the lower surface are defined as rake faces 1a and four side surfaces are defined as flank faces 1b. The four side surfaces are connected by arc faces and these arc faces are also defined as flank faces 1b. A ridgeline defined by an intersection between rake face 1a and flank face 1b and a vicinity of the ridgeline are defined as cutting edge 1c.

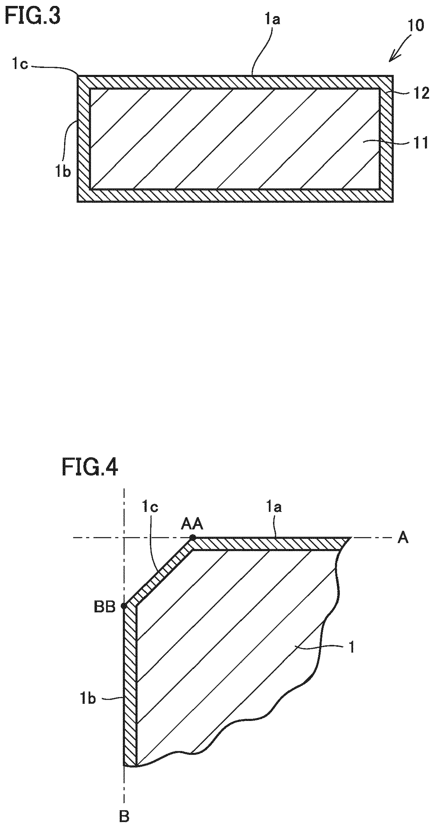

As shown in Fig. 3, tool 10 includes a substrate 11 including the rake face and the flank face and a coating 12 which covers the surface of substrate 11. Coating 12 may cover the entire surface of substrate 11 or a part thereof. Coating 12 should be provided at least on the rake face and the flank face which define cutting edge 1c.

Though Figs. 2 and 3 show a throwaway tip for turning, a shape and an application of the surface-coated cutting tool according to the present embodiment are not particularly restricted. Examples of the surface-coated cutting tool include a drill, an end mill, a throwaway tip for drilling, a throwaway tip for end milling, a throwaway tip for milling, a throwaway tip for turning, a metal saw, a gear cutting tool, a reamer, a tap, and a tip for pin milling of a crankshaft.

Though Figs. 2 and 3 show tool 10 with cutting edge 1c in a shape of a sharp edge, the shape of cutting edge 1c is not limited thereto. For example, as shown in Fig. 4, cutting edge 1c may be in a shape of a negative land. Fig. 4 shows a virtual plane A including rake face 1a, a virtual boundary line AA defining a boundary of separation between rake face 1a and virtual plane A, a virtual plane B including flank face 1b, and a virtual boundary line BB defining a boundary of separation between flank face 1b and virtual plane B. In this case, it is the vicinity of virtual boundary line BB in cutting edge 1c that is in contact with a work material.

The surface-coated cutting tool according to the present embodiment is not limited only to a surface-coated cutting tool constructed as above such that the entire tool includes the substrate and the coating formed on the substrate but also a surface-coated cutting tool constructed such that only a part thereof (in particular, a cutting edge portion) is constructed as above. For example, the surface-coated cutting tool according to the present embodiment includes also a surface-coated cutting tool constructed such that only a cutting edge portion of a base (a support) made of cemented carbide is constructed as above. In this case, that cutting edge portion is regarded as a cutting tool in its literal meaning. In other words, even in an example in which the construction above occupies only a part of a cutting tool, that construction is called a surface-coated cutting tool.

<<Substrate>>

Substrate 11 defines a basic shape of tool 10, and hence it is in a shape matching with a shape of each portion of the substrate (rake face 1a, flank face 1b, and cutting edge 1c). Substrate 11 in the present embodiment is made of a cBN sintered material or a ceramic sintered material.

(cBN Sintered Material)

A cBN sintered material includes a cBN sintered material made of particles composed of cubic boron nitride (which are also referred to as "cBN particles" below) and a binder and a cBN sintered material composed only of cBN particles. cBN particles are particularly excellent in hardness. The binder serves to bind cBN particles to one another and to compensate for relatively low heat resistance of the cBN particles.

A content of cBN particles in a cBN sintered material is not particularly restricted and can be determined as appropriate depending on an application of tool 10 and a material for a work material. Too low a content of cBN particles, however, may lead to insufficient characteristics as the cBN sintered material. Therefore, a content of cBN particles in a cBN sintered material is preferably not lower than 30 volume %. An upper limit of the content is not particularly restricted and can be set to 100 volume %. In this case, a hardness is particularly excellent.

A content of cBN particles in a cBN sintered material can be measured by a method shown below. Initially, a sample including a cross-section of substrate 11 is prepared by cutting any position in tool 10. In preparing a cross-section of substrate 11, a focused ion beam apparatus or a cross-section polisher can be employed. Then, a reflected electron image is obtained by observing a cross-section of a cBN sintered material with a scanning electron microscope (SEM) at a magnification of 2000x. In the reflected electron image, an area where cBN particles are located is observed as a black area and an area where a binder is located is observed as a gray or white area.

Then, the reflected electron image is subjected to binary processing with the use of image analysis software to thereby determine an area occupied by cBN particles based on the image subjected to binary processing. By substituting the obtained area occupied by cBN particles into an expression below, a content (volume %) of cBN particles in the cBN sintered material can be calculated. Volume % of the binder can also be calculated by a similar method. Alternatively, a transmission electron microscope (TEM) may be used.

$$[volume \% \ of \ cBN \ particles] = [area \ occupied \ by \ cBN \ particles]/[area \ of$$

$$structure \ of \ cBN \ sintered \ material \ in \ field \ image] \times 100$$

An average particle size ($D_{50}$) of cBN particles is not particularly restricted either, and it can be, for example, from 0.1 to 10 $\mu$m, preferably from 1 to 5 $\mu$m, and more preferably from 2 to 4 $\mu$m. Normally, a smaller average particle size tends to lead to high strength of a cBN sintered material, and less variation in particle size tends to lead to a homogenous property of the cBN sintered material.

An average particle size of cBN particles is calculated as below. Initially, a reflected electron image prepared as described above is analyzed by image analysis software to thereby calculate a Heywood diameter of each black area in the reflected electron image. Then, Heywood diameters of at least one hundred cBN particles are calculated by observing at least five fields of view. Then, cumulative distribution is found by arranging Heywood diameters from a minimum value to a maximum value. A particle size at which a cumulative area attains to 50% in the cumulative distribution is defined as $D_{50}$. The Heywood diameter means a diameter of a circle equal in measured area to a cBN particle.

A binder contained in a cBN sintered material is not particularly restricted, and a conventionally known binder can be employed. Among others, the binder preferably contains at least one compound composed of at least one first element selected from a group consisting of a group 4 element (Ti, Zr, Hf, and the like), a group 5 element (V, Nb, Ta, and the like), and a group 6 element (Cr, Mo, W, and the like) in the periodic table, Al, and Si and at least one second element selected from the group consisting of C, N, O, and B. Specific examples of such compounds include AlCrN, AlN, TiN, CrN, TiCN, NbCN, $Al_2O_3$, $AlB_2$, $TiB_2$, $ZrO_2$, $Cr_2O_3$, and $CrB_2$. Since the binder containing such a compound is excellent in adhesiveness to the coating, resistance against peeling of coating 12 in tool 10 can be improved.

Particularly, the binder preferably contains at least one of Al compounds composed of Al and at least one element selected from C, N, O, and B. In this case, resistance against peeling of tool 10 can further be improved. Specific examples of the Al compound include AlCrN, AlN, $Al_2O_3$, and $AlB_2$.

The binder may contain a compound composed of at least one element of W and Co and at least one element selected from the group consisting of N, B, and O. In this case, cBN particles are more firmly bonded to one another and hence a hardness of the substrate can be enhanced. Specific examples of such a compound include $W_3Co_3C$ and $W_3Co_{21}B_6$.

Which compound is contained in the binder can be checked, for example, by qualitatively analyzing a sample prepared as described above (a sample including a cross-section of substrate 11) with an X-ray diffraction (XRD) apparatus.

(Ceramic Sintered Material)

A conventionally known ceramic sintered material can be employed as the ceramic sintered material. Among others, from a point of view of excellent hardness, resistance against heat, and strength, a ceramic sintered material containing any of $Al_2O_3$, $ZrO_2$, $Si_3N_4$, and TiC is preferred. Of which compound the ceramic sintered material is composed can be checked, for example, by qualitatively analyzing a sample prepared as described above (a sample including a cross-section of substrate 11) with an X-ray diffraction (XRD) apparatus.

<<Coating>>

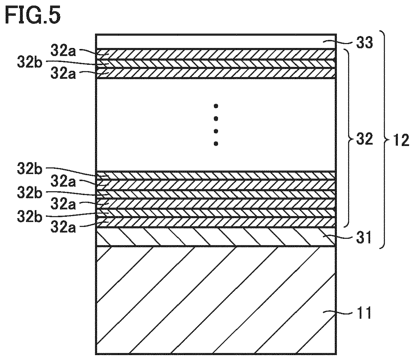

Coating 12 covers a surface of substrate 11 and thus provides various characteristics such as high heat resistance to tool 10. Coating 12 in the present embodiment includes, in particular, an alternating layer made by alternately stacking a first layer and a second layer different in composition from the first layer. Coating 12 may include another layer so long as it includes the alternating layer. For example, Fig. 5 shows coating 12 including an underlying layer 31 provided between alternating layer 32 and substrate 11 and a surface layer 33 defining an outermost surface of tool 10. Coating 12 according to the present embodiment will be described below with reference to Fig. 5.

Coating 12 can have a thickness, for example, from 0.5 to 20 $\mu$m. When coating 12 is smaller than 0.5 $\mu$m, it is difficult to include desired alternating layer 32 and an effect achieved by alternating layer 32 may not sufficiently be exhibited. Furthermore, coating 12 may insufficiently provide characteristics. When coating 12 is greater than 20 $\mu$m, coating 12 may peel off due to a high pressure applied during cutting. Coating 12 has a thickness preferably from 0.5 to 6 $\mu$m.

A thickness of coating 12 can be measured as below. Initially, a sample prepared as described above (a sample including a cross-section of substrate 11) is observed with an SEM or a TEM and a magnification is adjusted to include the entire coating in a direction of thickness in an observed image. Then, a thickness of the coating is measured at at least five points and an average value thereof is defined as the thickness of coating 12. A thickness of each layer which will be described in detail below can also be measured by a similar method.

(Alternating Layer)

Alternating layer 32 has a stack structure in which a first layer 32a and a second layer 32b different in composition from first layer 32a are alternately stacked. Alternating layer 32 has a thickness preferably from 0.5 to 20 $\mu$m. When the thickness of alternating layer 32 is smaller than 0.5 $\mu$m, an effect attributed to alternating layer 32 may insufficiently be exhibited, and when the thickness exceeds 20 $\mu$m, a crack in a layer in alternating layer 32 may occur and consequently alternating layer 32 may not contribute to improvement in wear resistance. Alternating layer 32 has a thickness more preferably from 0.5 to 8 $\mu$m and further preferably from 1 to 5 $\mu$m.

Alternating layer 32 constituted of first layer 32a and second layer 32b further satisfies each of features (1) to (5) below:

(1) First layer 32a contains Al, Cr, and N;
(2) Second layer 32b contains Ti, Al, and N;
(3) a ratio T1/T2 between thickness T1 of first layer 32a and thickness T2 of second layer 32b is not lower than 0.1 and lower than 1;
(4) There are thirty or more interfaces at which first layer 32a and second layer 32b are in contact with each other; and
(5) Thickness T1 and thickness T2 are each from 0.5 to 200 nm.

As to the feature (1), first layer 32a may contain another element so long as an effect of alternating layer 32 which will be described later is exhibited. Examples of another element include a metal element such as Ti, Zr, Hf, V, Nb, Ta, Mo, W, and Si and a non-metal element such as C, O, and B.

Among others, first layer 32a is preferably formed from a compound layer mainly composed of Al, Cr, and N among compound layers satisfying the above. This is because it has been found that such a compound layer is particularly excellent in characteristic of resistance against boundary wear and is suitable for exhibiting an effect of alternating layer 32 which will be described later.

The compound layer mainly composed of Al, Cr, and N means a compound layer in which at least 80 atomic % of the metal element is composed of Al and Cr and at least 80 atomic % of the non-metal element is composed of N. In particular, first layer 32a is preferably composed of Al, Cr, and N (which is also referred to as an "AlCrN layer" below) and the AlCrN layer is more preferably composed of $Al_xCr_{1-x}N$ ($0.3 \leq x \leq 0.75$).

As to the feature (2), second layer 32b may contain another element so long as an effect of alternating layer 32 which will be described later is exhibited. Examples of another element include a metal element such as Cr, Zr, Hf, V, Nb, Ta, Mo, W, and Si and a non-metal element such as C, O, and B.

Among others, second layer 32b is preferably composed of a compound mainly composed of Ti, Al, and N among the compound layers satisfying the above. This is because it has been found that such a compound layer is particularly excellent in characteristic of resistance against flank face wear and is suitable for exhibiting an effect of alternating layer 32 which will be described later.

The compound layer mainly composed of Ti, Al, and N means a compound layer in which at least 80 atomic % of the metal element is composed of Ti and Al and at least 80 atomic % of the non-metal element is composed of N. In particular, second layer 32b is preferably composed of Ti, Al, and N (which is also referred to as a "TiAlN layer" below) and the TiAlN layer is more preferably composed of $Ti_{1-y}Al_yN$ ($0.3 \leq y \leq 0.7$).

The feature (3) means that thickness T1 of first layer 32a is smaller than thickness T2 of second layer 32b. Ratio T1/T2 is preferably from 0.1 to 0.9.

The feature (4) means that one of the number of first layers 32a and the number of second layers 32b in alternating layer 32 is set to at least fifteen and the other thereof is set to at least sixteen. The number of interfaces is set preferably to at least fifty. The upper limit of the number of interfaces is preferably not greater than 500 from a point of view of a thickness of each layer and the entire thickness (a thickness of alternating layer 32).

As to the feature (5), thickness T1 and thickness T2 are each preferably from 1 to 200 nm and more preferably from 5 to 100 nm. Though first layers 32a may be different from one another in thickness, each of them is smaller in thickness than second layer 32b. In view of homogeneity of characteristics of the alternating layer, variation in thickness among first layers 32a and among second layers 32b is preferably not higher than 10 %.

Based on common and general technical knowledge thus far, it is assumed that first layer 32a such as the AlCrN layer is made larger in thickness than second layer 32b such as the TiAlN layer in order to extend a lifetime of a tool in precision machining. This is because, in order to improve surface finish Rz in precision machining and maintain such improved finish, more AlCrN layers higher in hardness and characteristic of resistance against boundary wear than the TiAlN layers excellent in characteristic of resistance against flank face wear are to be arranged for improvement in hardness and characteristic of resistance against boundary wear of the tool.

Surprisingly, however, tool 10 according to the present embodiment essentially requires that thickness T1 of first layer 32a is smaller than thickness T2 of second layer 32b. Though a reason therefor is unclear, it may be estimated from various results of studies that a form of damage to a cutting tool, in other words, balance between Vn and Vbmax, improves surface finish Rz owing to interaction between a thickness of each layer and the number of interfaces between the layers and consequently surface finish of a work material can be improved.

Though alternating layer 32 is described in detail above with reference to Fig. 5, the present inventors further obtained findings from another point of view in completing alternating layer 32. Specifically, the present inventors found that ratio Vn/Vbmax between boundary wear width Vn and maximum flank face wear width Vbmax was from 0.2 to 0.85 (Vbmax was from 30 to 70 $\mu$m) when hardened steel having HRC 60 was cut at a cutting speed from 150 to 200 m/min. with tool 10 including alternating layer 32 which satisfied (1) to (5) above and achieved the effect described above. It can be understood from this fact that the surface-coated cutting tool according to the present embodiment can include a compound layer which satisfies features (6) and (7) below, instead of the alternating layer.

(6) The compound layer contains Ti, Al, and N.
(7) When hardened steel having HRC 60 is cut at a cutting speed from 150 to 200 m/min., ratio Vn/Vbmax between boundary wear width Vn and maximum flank face wear width Vbmax is from 0.2 to 0.85 (Vbmax is from 30 to 70 $\mu$m).

As to the feature (7), Vbmax is defined as 30 $\mu$m or greater, because, when it is smaller than 30 $\mu$m, flank face wear may not sufficiently develop, which is not appropriate to evaluate wear characteristics. Vbmax is defined as 70 $\mu$m or smaller because wear of the coating is considered as dominant in flank face wear. In particular, based on common and general technical knowledge thus far, Vn/Vbmax can be considered as being preferably smaller. It is surprising, however, that a lifetime of the tool becomes shorter when Vn/Vbmax is lower than 0.2. Vn/Vbmax is more preferably from 0.5 to 0.82.

(Underlying Layer)

A construction of underlying layer 31 is not particularly restricted so long as it has a function to improve adhesiveness between alternating layer 32 and substrate 11, and a conventionally known compound layer can be adopted. Among others, the underlying layer is preferably similar in composition to any of first layer 32a and second layer 32b which constitute alternating layer 32, because adhesiveness can further be enhanced. A thickness of underlying layer 31 is not particularly restricted, and it can be set, for example, to 0.1 to 1 $\mu$m.

(Surface Layer)

Surface layer 33 can be, for example, a colored layer, because a state of use of a cutting tool can be identified based on a color of the surface. Examples of the colored layer include a $TiB_2$ layer and a TiN layer. Surface layer 33 may be formed from an AlCrN layer because it can provide lubrication or resistance against deposits. A thickness of surface layer 33 is not particularly restricted, and it can be set, for example, to 0.1 to 1 $\mu$m.

<Method of Manufacturing Surface-Coated Cutting Tool>

Tool 10 described above can be manufactured, for example, through each step below.

<<Step of Preparing Substrate>>

Initially, a substrate is prepared. A conventionally known sintering method can be adopted regardless of which of a cBN sintered material and a ceramic sintered material is employed as the substrate. When the surface-coated cutting tool in the present embodiment occupies only a part of a cutting tool, the substrate may be arranged at a prescribed position in a base metal which serves as a base for the cutting tool. By brazing the base metal and the substrate to each other, these members may be brought in intimate contact with each other. A substrate to be subjected to a step of forming a coating which will be described later may naturally be arranged at a prescribed position in the base metal.

<<Step of Forming Coating>>

A coating is then formed on a surface of the substrate. The coating can be formed by conventionally known chemical vapor deposition (CVD) or physical vapor deposition (PVD). PVD is a preferred formation method, and in particular, AIP (ion plating in which a solid material is evaporated by using vacuum arc discharge) or sputtering is preferably used.

In AIP, a coating can be formed by using a metal evaporation source containing a metal species which makes up a coating and reaction gas containing a non-metal element which makes up the coating. In sputtering, a coating can be formed by using a metal evaporation source, reaction gas, and sputtering gas such as Ar, Kr, or Xe. In any formation method, layers are formed by stacking desired layers successively from a side of substrate 11. A composition of each layer can be controlled by selecting a metal evaporation source and reaction gas, and a thickness of each layer can be controlled based on a time period for reaction.

The surface-coated cutting tool according to the present embodiment described in detail above can have a long lifetime also in precision machining. For example, surface finish Rz not greater than 3.2 $\mu$m and moreover not greater than 1.6 $\mu$m can be maintained. For example, when a cBN sintered material is employed as a substrate, finishing with Rz as above of a work material high in hardness such as hardened steel can be achieved.

Examples

Though the present invention will be described hereinafter in further detail with reference to Examples, the present invention is not limited thereto.

<Method of Measuring Each Value>

A content of cBN in a substrate was found in accordance with the method described above by using an SEM and image analysis software ("WinROOF" of Mitani Corporation). A particle size of cBN particles was measured in accordance with the method described above by using the image analysis software. A type of a compound contained in the substrate was identified in accordance with the method described above by using an X-ray diffraction apparatus ("Smart-Lab" manufactured by Rigaku Corporation). A thickness of each layer constituting the coating was measured in accordance with the method described above by using an SEM. A composition of each layer was identified by using an SEM-EDX apparatus or a TEM-EDX apparatus.

<Preparation of Substrate>

cBN sintered materials A to H were manufactured by using cBN particles and binders shown in Table 1. A compound shown in the field of "X-ray detected compound" in Table 1 refers to a compound detected in qualitative analysis by the X-ray diffraction apparatus.

Table 1

| Substrate | cBN Particles | | Binder (Source Material Powders) | X-Ray Detected Compound |
| | Content (Vol %) | D50 ($\mu$m) | | |
| --- | --- | --- | --- | --- |
| A | 60 | 3 | $TiN_{0.7}$, Al | cBN, TiN, $TiB_2$, AlN, $AlB_2$ |
| B | 75 | 3 | $TiN_{0.7}$, Al | cBN, TiN, $TiB_2$, AlN, $AlB_2$ |
| C | 50 | 2 | $Ti(CN)_{0.7}$, Al, $Al_2O_3$ | cBN, TiCN, $TiB_2$, AlN, $AlB_2$, $Al_2O_3$ |
| D | 60 | 4 | $Ti(CN)_{0.7}$, Al | cBN, TiCN, $TiB_2$, AlN, $AlB_2$ |
| E | 30 | 4 | $TiC_{0.7}$, Al | cBN, TiC, $TiB_2$, AlN, $AlB_2$ |
| F | 80 | 2 | $TiN_{0.7}$, Al, WC, $W_3Co_3C$ | cBN, TiN, $TiB_2$, AlN, $AlB_2$, WC, $W_3Cl_3C$ |
| G | 60 | 2 | $TiN_{0.7}$, Al, $ZrO_2$, $Al_2O_3$ | cBN, TiN, $ZrO_2$, $TiB_2$, AlN, $AlB_2$, $Al_2O_3$ |
| H | 60 | 2 | $Nb(CN)_{0.7}$, $Al_2O_3$ | cBN, NbCN, $TiB_2$, AlN, $AlB_2$, $Al_2O_3$ |

<<Fabrication of cBN Sintered Material A>>

cBN sintered material A was fabricated as below. Initially, a mixture was obtained by mixing TiN powders ($D_{50}$ = 1 $\mu$m) and Ti powders ($D_{50}$ = 3 $\mu$m) so as to achieve an atomic ratio Ti:N = 1:0.6. The mixture was subjected to heat treatment at 1200°C in vacuum for 30 minutes. Intermetallic compound powders composed of $TiN_{0.7}$ were obtained by crushing a compound obtained by heat treatment.

Then, a mixture was obtained by mixing the intermetallic compound powders composed of $TiN_{0.7}$ and Al powders ($D_{50}$ = 4 $\mu$m) so as to achieve a mass ratio $TiN_{0.7}$:Al = 9:1. The mixture was subjected to heat treatment at 1000°C in vacuum for 30 minutes. A compound obtained by heat treatment was uniformly crushed by ball mill crushing. A ball medium having a diameter of 6 mm and made of cemented carbide was used for crushing. Source material powders of a binder were thus obtained.

Then, a powdery mixture was obtained by blending cBN particles ($D_{50}$ = 3 $\mu$m) and the source material powders such that a content of cBN in the cBN sintered material was set to 60 volume % and by uniformly mixing the blend by ball mill mixing. A ball medium having a diameter of 3 mm and made of boron nitride was used for mixing. The obtained mixture was layered on a support substrate made of cemented carbide, and a capsule made of Mo was filled therewith. The capsule was placed in an ultra-high pressure apparatus and sintering was performed at a pressure of 5.5 GPa and a temperature of 1300°C for 30 minutes.

<<cBN Sintered Materials B to H>>

cBN sintered materials B to H were fabricated by changing as appropriate a type of source material powders of a binder, a particle size of cBN particles, and a ratio of blending of the source material powders and cBN particles as compared with the method of fabricating cBN sintered material A described above.

<Discussion 1: Samples Nos. 1 to 8>

<<Fabrication of Tool Substrate>>

cBN sintered material A was shaped into a triangular prism having a thickness of 2 mm and a bottom surface in a shape of an isosceles triangle of which vertical angle was 80° and sides forming the vertical angle therebetween each had a length of 2 mm. cBN sintered material A in the shape above was joined to a cutting edge (a corner portion) of a base shaped into CNGA120408 S01225 under the ISO standards and composed of a cemented carbide material (equivalent to K10). A brazing material composed of Ti-Zr-Cu was employed for joint.

Then, an outer peripheral surface, an upper surface, and a lower surface of the obtained joined body were ground, and a negative land shape (a width of the negative land being set to 120 $\mu$m, an angle of the negative land being set to 25°, and with honing) was formed at the cutting edge. A tool substrate of which cutting edge portion was made of cBN sintered material A was thus fabricated.

<<Fabrication of Coating>>

A surface-coated cutting tool of each of samples Nos. 1 to 8 was fabricated by forming a coating shown in Table 2 on a surface of the fabricated tool substrate. Table 2 shows a thickness of the coating and a composition and a thickness of each layer. For the alternating layer, the table shows a ratio between thickness T1 of the first layer and thickness T2 of the second layer, the number of layers, and the number of interfaces where the first layer and the second layer are in contact with each other.

Table 2

| | No. | Substrate | Underlying Layer | | Alternating Layer | | | | | | | | | Surface Layer | | Coating |
|---|---|---|---|---|---|---|---|---|---|---|---|---|---|---|---|---|
| | | | | | Second Layer | | | First Layer | | | The Number of Interfaces | Thickness (μm) | T1/T2 | | | |
| | | | Composition | Thickness (μm) | Composition | T2 (nm) | The Number of Layers | Composition | T1 (nm) | The Number of Layers | | | | Composition | Thickness (μm) | Thickness (μm) |
| Comparative Example | No. 1 | A | Al$_{0.7}$Cr$_{0.3}$N | 0.3 | Ti$_{0.5}$Al$_{0.5}$N | 4900 | 1 | Al$_{0.7}$Cr$_{0.3}$N | - | 0 | 0 | 4.9 | - | - | - | 5.2 |
| | No. 2 | | | | | 3900 | 1 | | 1000 | 1 | 1 | | 0.26 | | | |
| Example | No. 3 | | | | | 190 | 20 | | 57 | 20 | 39 | | 0.30 | | | |
| | No. 4 | | | | | 100 | 38 | | 30 | 38 | 75 | | 0.30 | | | |
| | No. 5 | | | | | 50 | 75 | | 15 | 75 | 149 | | 0.30 | | | |
| | No. 6 | | | | | 25 | 150 | | 7.5 | 150 | 299 | | 0.30 | | | |
| | No. 7 | | | | | 10 | 375 | | 3 | 375 | 749 | | 0.30 | | | |
| | No. 8 | | | | | 2.7 | 1400 | | 0.8 | 1400 | 2799 | | 0.30 | | | |

EP 3 527 309 A1

11

Each coating was manufactured by cold cathode arc ion plating. A film formation apparatus used for fabricating a coating will initially be described. A vacuum pump is connected to the film formation apparatus and the apparatus contains a vacuum chamber in which vacuum can be produced. A turntable is placed in the vacuum chamber and constructed such that a tool substrate can be set thereon with a jig being interposed. The tool substrate set in the vacuum chamber can be heated by a heater provided in the vacuum chamber. A gas pipe for introducing gas for etching and film formation is connected to the vacuum chamber with a mass flow controller for flow rate control being interposed. In the vacuum chamber, a tungsten filament for generating Ar ions for etching and an arc evaporation source for film formation to which a necessary power supply is connected are arranged in the vacuum chamber. A target necessary for film formation is set on the arc evaporation source.

(Etching of Tool Substrate)

The tool substrate was set in the vacuum chamber of the film formation apparatus and vacuum was produced in the chamber. Thereafter, the tool substrate was heated to 500°C while the turntable was turned at 3 rpm. Then, Ar gas was introduced into the vacuum chamber, Ar ions were generated by discharging of the tungsten filament, and a bias voltage was applied to the tool substrate. The tool substrate was thus etched by Ar ions. Conditions for etching at this time are shown below.

Pressure of Ar gas: 1 Pa
Substrate bias voltage: -500 V

(Fabrication of Underlying Layer)

An underlying layer was then formed on the tool substrate in the film formation apparatus. Specifically, the underlying layer was fabricated with a time period for vapor deposition being adjusted to form a layer to a thickness of 0.3 $\mu$m under film formation conditions below.

Target: Al (70 atomic %) and Cr (30 atomic %)
Introduced gas: $N_2$
Film formation pressure: 4 Pa
Arc discharge current: 150 A
Substrate bias voltage: -35 V
The number of revolutions of table: 3 rpm

(Fabrication of Alternating Layer)

The alternating layer was then formed on the underlying layer. Specifically, the second layer was fabricated under film formation conditions below.

Target: Ti (50 atomic %) and Al (50 atomic %)
Introduced gas: $N_2$
Film formation pressure: 4 Pa
Arc discharge current: 80 to 250 A
Substrate bias voltage: -35 V
The number of revolutions of table: 0.5 to 50 rpm

The first layer was fabricated under film formation conditions below.

Target: Al (70 atomic %) and Cr (30 atomic %)
Introduced gas: $N_2$
Film formation pressure: 4 Pa
Arc discharge current: 80 to 250 A
Substrate bias voltage: -35 V
The number of revolutions of table: 0.5 to 50 rpm

Though a thickness of each layer and the total number of layers are different among Nos. 1 to 8, a thickness of each layer was controlled by adjusting the arc discharge current and the number of revolutions of the table within the ranges above, and the total number of layers was controlled by adjusting the number of revolutions of the table and a time period for treatment. In Nos. 2 to 8, a TiAlN layer was provided as a lowermost layer of the alternating layer (on a side of the underlying layer) and an AlCrN layer was provided as an uppermost layer thereof. Surface-coated cutting tools Nos. 1 to 8 were manufactured as set forth above.

<Evaluation of Characteristics>

<<Cutting Test>>

Cutting under cutting conditions below was performed with the use of the surface-coated cutting tools of Nos. 1 to 8. Then, maximum flank face wear width Vbmax (mm) after cutting by 5 km was measured. A cutting distance (km) at the time point when surface finish Rz of a work material attained to 3.2 $\mu$m was also measured. Surface roughness Rz refers to a ten point height of roughness profile (Rz) under JIS B 0031: 1994.

(Cutting Condition)

Work material: SCM415 round rod (having a hardness of HRC 60)
Cutting speed: 200 m/min.
Feed rate: 0.1 mm/rev.
Depth of cutting: 0.1 mm
Cutting oil: Used

Ratio Vn/Vbmax between boundary wear width Vn and maximum flank face wear width Vbmax of each surface-coated cutting tool was calculated. Specifically, ratio Vn/Vbmax was calculated by performing cutting under cutting conditions below and measuring Vn (mm) and Vbmax (mm) while Vbmax was within a range from 30 to 70 $\mu$m. Table 3 shows each result.

(Cutting Condition)

Work material: SCM415 round rod (having a hardness of HRC 60)
Cutting speed: 180 m/min.
Feed rate: 0.1 mm/rev.
Depth of cutting: 0.1 mm
Cutting oil: Used

Table 3

|  |  | Vbmax ($\mu$m) | km | Vn/Vbmax |
|---|---|---|---|---|
| Comparative Example | No. 1 | 32 | 3.3 | 0.91 |
|  | No. 2 | 32 | 3.3 | 0.86 |
| Example | No. 3 | 33 | 4.8 | 0.80 |
|  | No. 4 | 33 | 5.9 | 0.77 |
|  | No. 5 | 34 | 8.1 | 0.75 |
|  | No. 6 | 38 | 7.1 | 0.76 |
|  | No. 7 | 41 | 5.6 | 0.80 |
|  | No. 8 | 50 | 4.1 | 0.83 |

A smaller value for Vbmax indicates excellent resistance against flank face wear. A longer cutting distance (km) at the time point when surface finish Rz of the work material attained to 3.2 $\mu$m indicates a longer lifetime. It was found that, when the alternating layer satisfied the features (1) to (5) above, the surface-coated cutting tool could have a long lifetime as shown in Table 3. Ratio Vn/Vbmax of the surface-coated cutting tool including such an alternating layer was from 0.75 to 0.83, which satisfied the range from 0.2 to 0.85. It was understood that, since the lifetime of Nos. 5 and 6 was particularly long, a long lifetime could not be achieved simply by decreasing Vbmax.

<Discussion 2: Samples Nos. 9 to 15>

<<Fabrication of Coating>>

A surface-coated cutting tool of each of samples Nos. 9 to 15 was fabricated by forming a coating shown in Table 4 on a surface of a tool substrate fabricated by a method the same as in Discussion 1 (cBN sintered material B being employed as the substrate).

Table 4

| | | Substrate | Underlying Layer | | Alternating Layer | | | | | | | | | Surface Layer | | Coating |
|---|---|---|---|---|---|---|---|---|---|---|---|---|---|---|---|---|
| | | | | | Second Layer | | | First Layer | | | The Number of Interfaces | Thickness ($\mu$m) | T1/T2 | | | |
| | | | Composition | Thickness ($\mu$m) | Composition | T2 (nm) | The Number of Layers | Composition | T1 (nm) | The Number of Layers | | | | Composition | Thickness ($\mu$m) | Thickness ($\mu$m) |
| Comparative Example | No. 9 | B | $Al_{0.7}T_{0.3}N$ | 0.5 | $Ti_{0.3}Al_{0.7}N$ | 3000 | 1 | $Al_{0.6}Cr_{0.4}N$ | - | 0 | 0 | 3 | - | $Al_{0.5}Cr_{0.5}N$ | 0.3 | 3.8 |
| Example | No. 10 | | | | | 57 | 50 | | 3 | 50 | 99 | | 0.05 | | | |
| | No. 11 | | | | | 50 | 50 | | 10 | 50 | 99 | | 0.20 | | | |
| | No. 12 | | | | | 45 | 50 | | 15 | 50 | 99 | | 0.33 | | | |
| | No. 13 | | | | | 40 | 50 | | 20 | 50 | 99 | | 0.50 | | | |
| | No. 14 | | | | | 32 | 50 | | 28 | 50 | 99 | | 0.88 | | | |
| Comparative Example | No. 15 | | | | | 12 | 50 | | 48 | 50 | 99 | | 4.0 | | | |

Each coating was fabricated by using a method and a film formation apparatus the same as those in Discussion 1. Conditions for forming the underlying layer and the alternating layer were similar to those in Discussion 1 except for change in metal element of the target so as to match with the composition of each layer. Surface-coated cutting tools of Nos. 9 to 15 were manufactured as set forth above. Conditions for forming a surface layer are as below.

(Surface Layer)

Target: Al (50 atomic %) and Cr (50 atomic %)
Introduced gas: $N_2$
Film formation pressure: 4 Pa
Arc discharge current: 150 A
Substrate bias voltage: -50 V
The number of revolutions of table: 2 rpm

<Evaluation of Characteristics>

<<Cutting Test>>

Cutting under cutting conditions below was performed with the use of the surface-coated cutting tools of Nos. 9 to 15. Vbmax (mm) and a cutting distance (km) were calculated by a method the same as in Discussion 1. Table 5 shows each result.

(Cutting Condition)

Work material: SCM415 round rod (having a hardness of HRC 60)
Cutting speed: 150 m/min.
Feed rate: 0.1 mm/rev.
Depth of cutting: 0.1 mm
Cutting oil: Used

Ratio Vn/Vbmax of each surface-coated cutting tool was calculated by performing the method the same as in Discussion 1 under cutting conditions below.
Table 5 shows each result.

(Cutting Condition)

Work material: SCM415 round rod (having a hardness of HRC 60)

Cutting speed: 160 m/min.

Feed rate: 0.1 mm/rev.

Depth of cutting: 0.1 mm

Cutting oil: Used

Table 5

|  |  | Vbmax ($\mu$m) | km | Vn/Vbmax |
|---|---|---|---|---|
| Comparative Example | No. 9 | 42 | 2.8 | 0.91 |

(continued)

|  | | Vbmax ($\mu$m) | km | Vn/Vbmax |
|---|---|---|---|---|
| Example | No. 10 | 43 | 4.0 | 0.83 |
| | No. 11 | 45 | 4.6 | 0.72 |
| | No. 12 | 46 | 5.2 | 0.65 |
| | No. 13 | 48 | 5.9 | 0.57 |
| | No. 14 | 52 | 6.3 | 0.50 |
| Comparative Example | No. 15 | 92 | 2.0 | 0.15 |

As shown in Table 5, it was found that the surface-coated cutting tool could have a long lifetime when the alternating layer satisfied the features (1) to (5) above. Ratio Vn/Vbmax of the surface-coated cutting tool including such an alternating layer was from 0.5 to 0.83, which satisfied the range from 0.2 to 0.85. A short tool lifetime of No. 15 is surprising in consideration of particularly excellent hardness of a single layer of AlCrN.

<Discussion 3: Samples Nos. 16 to 21>

<<Fabrication of Coating>>

A surface-coated cutting tool of each of samples Nos. 16 to 21 was fabricated by forming a coating shown in Table 6 on a surface of a tool substrate fabricated by a method the same as in Discussion 1 (cBN sintered material C being employed as the substrate).

Table 6

| | | Substrate | Underlying Layer | | Alternating Layer | | | | | | | | | Surface Layer | | Coating |
| | | | Composi-tion | Thickess ($\mu$m) | Second Layer | | | First Layer | | | The Number of Inter-faces | Thick-ness ($\mu$m) | T1/T2 | Composi-tion | Thick-ness ($\mu$m) | Thick-ness ($\mu$m) |
| | | | | | Composition | T2 (nm) | The Number of Layers | Composition | T1 (nm) | The Number of Lay-ers | | | | | | |
| Compara-tive Example | No. 16 | C | $Ti_{0.5}Al_{0.5}N$ | 0.2 | $Ti_{0.7}Al_{0.3}N$ | 4000 | 1 | - | - | 0 | 0 | 4.0 | - | TiN | 0.7 | 4.9 |
| Example | No. 17 | | | | | 200 | 16 | $Al_{0.75}Cr_{0.25}N$ | 50 | 16 | 31 | 4.0 | 0.25 | | | 4.9 |
| | No. 18 | | | | | 200 | 16 | $Ti_{0.2}Al_{0.4}Cr_{0.4}N$ | 40 | 16 | 31 | 3.8 | 0.20 | | | 4.7 |
| | No. 19 | | | | | 200 | 16 | $Al_{0.5}Cr_{0.4}V_{0.1}N$ | 70 | 16 | 31 | 4.3 | 0.35 | | | 5.2 |
| | No. 20 | | | | $Ti_{0.45}Al_{0.5}Si_{0.05}C_{0.1}N_{0.9}$ | 200 | 16 | $Al_{0.5}Cr_{0.45}Si_{0.05}C_{0.1}N_{0.9}$ | 70 | 16 | 31 | 4.3 | 0.35 | | | 5.2 |
| | No. 21 | | | | $Ti_{0.3}Al_{0.6}Nb_{0.1}N$ | 200 | 16 | $Al_{0.5}Cr_{0.5}N$ | 70 | 16 | 31 | 4.3 | 0.35 | | | 5.2 |

Each coating was fabricated by using a method and a film formation apparatus the same as those in Discussion 1. Conditions for forming the underlying layer, the alternating layer, and the surface layer were similar to those in Discussions 1 and 2 except for change in metal element of the target so as to match with the composition of each layer. Surface-coated cutting tools of Nos. 16 to 21 were manufactured as set forth above.

<Evaluation of Characteristics>

<<Cutting Test>>

Cutting under cutting conditions below was performed with the use of the surface-coated cutting tools of Nos. 16 to 21. Vbmax (mm) and a cutting distance (km) were calculated by a method the same as in Discussion 1. Table 7 shows each result.

(Cutting Condition)

Work material: SCM415 round rod (having a hardness of HRC 60)
Cutting speed: 100 m/min.
Feed rate: 0.1 mm/rev.
Depth of cutting: 0.1 mm
Cutting oil: Used

Ratio Vn/Vbmax of each surface-coated cutting tool was calculated by performing the method the same as in Discussion 1 under cutting conditions below.
Table 7 shows each result.

(Cutting Condition)

Work material: SCM415 round rod (having a hardness of HRC 60)
Cutting speed: 150 m/min.
Feed rate: 0.1 mm/rev.
Depth of cutting: 0.1 mm
Cutting oil: Used

Table 7

| | | Vbmax ($\mu$m) | km | Vn/Vbmax |
|---|---|---|---|---|
| Comparative Example | No. 16 | 38 | 2.6 | 0.90 |
| Example | No. 17 | 41 | 4.1 | 0.84 |
| | No. 18 | 39 | 5.2 | 0.80 |
| | No. 19 | 44 | 5.3 | 0.75 |
| | No. 20 | 42 | 4.9 | 0.60 |
| | No. 21 | 40 | 5.1 | 0.40 |

As shown in Table 7, it was found that the surface-coated cutting tool could have a long lifetime when the alternating layer satisfied the features (1) to (5) above. Ratio Vn/Vbmax of the surface-coated cutting tool including such an alternating layer was from 0.40 to 0.84, which satisfied the range from 0.2 to 0.85.

<Discussion 4: Samples Nos. 22 to 27>

<<Fabrication of Coating>>

A surface-coated cutting tool of each of samples Nos. 22 to 27 was fabricated by forming a coating shown in Table 8 on a surface of a tool substrate fabricated by a method the same as in Discussion 1 (cBN sintered material D being employed as the substrate).

Table 8

| | | Substrate | Underlying Layer | | Alternating Layer | | | | | | | | | | Surface Layer | | Coating |
|---|---|---|---|---|---|---|---|---|---|---|---|---|---|---|---|---|---|
| | | | | | Second Layer | | | First Layer | | | The Number of Interfaces | Thickness (μm) | T1/T2 | | | | |
| | | | Composition | Thickness (μm) | Composition | T2 (nm) | The Number of Layers | Composition | T1 (nm) | The Number of Layers | | | | Composition | Thickness (μm) | Thickness (μm) |
| Example | No. 22 | D | $Al_{0.5}Cr_{0.5}N$ | 0.3 | $Ti_{0.8}Al_{0.1}Ta_{0.1}N$ | 30 | 245 | $Al_{0.4}Cr_{0.4}Nb_{0.2}N$ | 15 | 245 | 489 | 11.0 | 0.50 | - | - | 11.3 |
| | No. 23 | | | | | | 175 | | | 175 | 349 | 7.9 | | | | 8.2 |
| | No. 24 | | | | | | 135 | | | 135 | 269 | 6.1 | | | | 6.4 |
| | No. 25 | | | | | | 90 | | | 90 | 179 | 4.1 | | | | 4.4 |
| | No. 26 | | | | | | 45 | | | 45 | 89 | 2.0 | | | | 2.3 |
| | No. 27 | | | | | | 18 | | | 18 | 35 | 0.8 | | | | 1.1 |

Each coating was fabricated by using a method and a film formation apparatus the same as those in Discussion 1. Conditions for forming the underlying layer and the alternating layer were similar to those in Discussion 1 except for change in metal element of the target so as to match with the composition of each layer. Surface-coated cutting tools of Nos. 22 to 27 were manufactured as set forth above.

<Evaluation of Characteristics>

<<Cutting Test>>

Cutting under cutting conditions below was performed with the use of the surface-coated cutting tools of Nos. 22 to 27. Vbmax (mm) and a cutting distance (km) were calculated by a method the same as in Discussion 1. Table 9 shows each result.

(Cutting Condition)

Work material: SCM415 round rod (having a hardness of HRC 58)
Cutting speed: 100 m/min.
Feed rate: 0.1 mm/rev.
Depth of cutting: 0.15 mm
Cutting oil: Used

Ratio Vn/Vbmax of each surface-coated cutting tool was calculated by performing the method the same as in Discussion 1 under cutting conditions below.
Table 9 shows each result.

(Cutting Condition)

Work material: SCM415 round rod (having a hardness of HRC 58)
Cutting speed: 150 m/min.
Feed rate: 0.1 mm/rev.
Depth of cutting: 0.15 mm
Cutting oil: Used

Table 9

|  |  | Vbmax ($\mu$m) | km | Vn/Vbmax |
|---|---|---|---|---|
| Example | No. 22 | 40 | 7.2 | 0.70 |
|  | No. 23 | 47 | 6.1 | 0.71 |
|  | No. 24 | 55 | 5.3 | 0.72 |
|  | No. 25 | 64 | 4.9 | 0.73 |
|  | No. 26 | 67 | 4.5 | 0.75 |
|  | No. 27 | 70 | 4.1 | 0.80 |

As shown in Table 9, it was found that the surface-coated cutting tool could have a long lifetime when the alternating layer satisfied the features (1) to (5) above.
Ratio Vn/Vbmax of the surface-coated cutting tool including such an alternating layer was from 0.7 to 0.8, which satisfied the range from 0.2 to 0.85. It was confirmed that the lifetime was longer as the number of interfaces in the alternating layer was greater. The alternating layer had a thickness from 0.8 to 11 $\mu$m at this time.

<Discussion 5: Samples Nos. 28 to 35>

<<Fabrication of Coating>>

A surface-coated cutting tool of each of samples Nos. 28 to 35 was fabricated by forming a coating shown in Table 10 on a surface of a tool substrate fabricated by a method the same as in Discussion 1 (cBN sintered materials E to H being employed as the substrate).

Table 10

| | | Substrate | Underlying Layer | | Alternating Layer | | | | | | | | | Surface Layer | | Coating |
|---|---|---|---|---|---|---|---|---|---|---|---|---|---|---|---|---|
| | | | | | Second Layer | | | First Layer | | | The Number of Interfaces | Thickness ($\mu$m) | T1/T2 | | | |
| | | | Composition | Thickness ($\mu$m) | Composition | T2 (nm) | The Number of Layers | Composition | T1 (nm) | The Number of Layers | | | | Composition | Thickness ($\mu$m) | Thickness ($\mu$m) |
| Example | No. 28 | E | $Al_{0.7}Cr_{0.3}N$ | 0.5 | $Ti_{0.4}Al_{0.6}N$ | 70 | 30 | $Al_{0.6}Cr_{0.4}N$ | 20 | 30 | 59 | 2.7 | 0.29 | TiN | 0.3 | 3.5 |
| Comparative Example | No. 29 | E | | | $Ti_{0.5}Al_{0.5}N$ | 2200 | 1 | - | - | 0 | 0 | | - | - | - | 3.2 |
| Example | No. 30 | F | | | $Ti_{0.4}Al_{0.6}N$ | 70 | 30 | $Al_{0.6}Cr_{0.4}N$ | 20 | 30 | 59 | | 0.29 | TiN | 0.3 | 3.5 |
| Comparative Example | No. 31 | F | | | $Ti_{0.5}Al_{0.5}N$ | 2200 | 1 | - | - | 0 | 0 | | - | - | - | 3.2 |
| Example | No. 32 | G | | | $Ti_{0.4}Al_{0.6}N$ | 70 | 30 | $Al_{0.6}Cr_{0.4}N$ | 20 | 30 | 59 | | 0.29 | TiN | 0.3 | 3.5 |
| Comparative Example | No. 33 | G | | | $Ti_{0.5}Al_{0.5}N$ | 2200 | 1 | - | - | 0 | 0 | | - | - | - | 3.2 |
| Example | No. 34 | H | | | $Ti_{0.4}Al_{0.6}N$ | 70 | 30 | $Al_{0.6}Cr_{0.4}N$ | 20 | 30 | 59 | | 0.29 | TiN | 0.3 | 3.5 |
| Comparative Example | No. 35 | H | | | $Ti_{0.5}Al_{0.5}N$ | 2200 | 1 | - | - | 0 | 0 | | - | - | - | 3.2 |

Each coating was fabricated by using a method and a film formation apparatus the same as those in Discussion 1. Conditions for forming the underlying layer, the alternating layer, and the surface layer were similar to those in Discussions 1 and 2 except for change in metal element of the target so as to match with the composition of each layer. Surface-coated cutting tools of Nos. 28 to 35 were manufactured as set forth above.

<Evaluation of Characteristics>

<<Cutting Test>>

Cutting under cutting conditions below was performed with the use of the surface-coated cutting tools of Nos. 28 to 35. Vbmax (mm) and a cutting distance (km) were calculated by a method the same as in Discussion 1. Table 11 shows each result.

(Cutting Condition)

Work material: SCM415 round rod (having HRC 58)
Cutting speed: 200 m/min.
Feed rate: 0.1 mm/rev.
Depth of cutting: 0.1 mm
Cutting oil: None

Ratio Vn/Vbmax of each surface-coated cutting tool was calculated by performing the method the same as in Discussion 1 under cutting conditions below.
Table 11 shows each result.

(Cutting Condition)

Work material: SCM415 round rod (having a hardness of HRC 58)
Cutting speed: 200 m/min.
Feed rate: 0.1 mm/rev.
Depth of cutting: 0.1 mm
Cutting oil: Used

Table 11

|  |  |  | Vbmax ($\mu$m) | km | Vn/Vbmax |
|---|---|---|---|---|---|
| Example | No. 28 | | 50 | 4.8 | 0.79 |
| Comparative Example | No. 29 | | 41 | 3.6 | 0.89 |
| Example | No. 30 | | 70 | 5.2 | 0.79 |
| Comparative Example | No. 31 | | 62 | 3.9 | 0.89 |
| Example | No. 32 | | 67 | 5.1 | 0.79 |
| Comparative Example | No. 33 | | 56 | 3.7 | 0.89 |
| Example | No. 34 | | 64 | 4.9 | 0.79 |
| Comparative Example | No. 35 | | 53 | 3.5 | 0.89 |

As shown in Table 11, it was found that the surface-coated cutting tool could have a long lifetime when the alternating layer satisfied the features (1) to (5) above. Ratio Vn/Vbmax of the surface-coated cutting tool including such an alternating layer was 0.79.
It should be understood that the embodiment disclosed herein is illustrative and non-restrictive in every respect.

The scope of the present invention is defined by the terms of the claims rather than the embodiment above and is intended to include any modifications within the scope and meaning equivalent to the terms of the claims.

REFERENCE SIGNS LIST

1a rake face; 1b flank face; 1c cutting edge; 10 surface-coated cutting tool; 11 substrate; 12 coating; 20 crater wear; 21 flank face wear; 22a, 22b boundary wear; 31 underlying layer; 32 alternating layer; 32a first layer; 32b second layer

**Claims**

1. A surface-coated cutting tool including a substrate including a rake face and a flank face and a coating which covers a surface of the substrate,
   the substrate being made of a cubic boron nitride sintered material or a ceramic sintered material,
   the coating including an alternating layer,
   the alternating layer being made by alternately stacking a first layer and a second layer different in composition from the first layer,
   the first layer containing Al, Cr, and N,
   the second layer containing Ti, Al, and N,
   a ratio T1/T2 between a thickness T1 of the first layer and a thickness T2 of the second layer being not lower than 0.1 and lower than 1, and
   there being thirty or more interfaces at which the first layer and the second layer are in contact with each other.

2. The surface-coated cutting tool according to claim 1, wherein
   the thickness T1 and the thickness T2 are each not smaller than 0.5 nm and not greater than 200 nm.

3. The surface-coated cutting tool according to claim 1 or 2, wherein
   the first layer is composed of $Al_xCr_{1-x}N$ ($0.3 \le x \le 0.75$), and
   the second layer is composed of $Ti_{1-y}Al_yN$ ($0.3 \le y \le 0.7$).

4. The surface-coated cutting tool according to any one of claims 1 to 3, wherein
   the alternating layer has a thickness not smaller than 0.5 $\mu$m and not greater than 20 $\mu$m.

5. A surface-coated cutting tool including a substrate including a rake face and a flank face and a coating which covers a surface of the substrate,
   the substrate being made of a cubic boron nitride sintered material or a ceramic sintered material,
   the coating including a compound layer containing Ti, Al, and N, and
   the compound layer having a ratio Vn/Vbmax between a boundary wear width Vn and a maximum flank face wear width Vbmax not lower than 0.2 and not higher than 0.85 (Vbmax being not smaller than 30 $\mu$m and not greater than 70 $\mu$m) when hardened steel having HRC 60 is cut at a cutting speed not lower than 150 m/min. and not higher than 200 m/min.

FIG.1

1a   20

1c

22a

22b   Vn

Vbmax

1b

21

FIG.2

1b   1a   10

III

1b   1b

III

1b   1c

1a   1c   1b

FIG.3

FIG.4

FIG.5

## INTERNATIONAL SEARCH REPORT

| International application No. |
|---|
| PCT/JP2017/033962 |

A.   CLASSIFICATION OF SUBJECT MATTER
*B23B27/14*(2006.01)i, *B23B51/00*(2006.01)i, *B23C5/16*(2006.01)i, *B23D77/00*
(2006.01)i, *B23F21/00*(2006.01)i, *B23G5/06*(2006.01)i, *C23C14/06*(2006.01)i,
*C23C16/34*(2006.01)i
According to International Patent Classification (IPC) or to both national classification and IPC

B.   FIELDS SEARCHED

Minimum documentation searched (classification system followed by classification symbols)
B23B27/14, B23B51/00, B23C5/16, B23D77/00, B23F21/00, B23G5/06, C23C14/06,
C23C16/34

Documentation searched other than minimum documentation to the extent that such documents are included in the fields searched
　　Jitsuyo Shinan Koho　　　　1922–1996　Jitsuyo Shinan Toroku Koho　1996–2017
　　Kokai Jitsuyo Shinan Koho　1971–2017　Toroku Jitsuyo Shinan Koho　1994–2017

Electronic data base consulted during the international search (name of data base and, where practicable, search terms used)
　　WPI

C.   DOCUMENTS CONSIDERED TO BE RELEVANT

| Category* | Citation of document, with indication, where appropriate, of the relevant passages | Relevant to claim No. |
|---|---|---|
| X | WO 2014/002948 A1  (Sumitomo Electric Hardmetal Corp.),<br>03 January 2014 (03.01.2014),<br>paragraphs [0019] to [0020], [0033] to [0045], [0126] to [0134]; table 6, particularly, example 31<br>& US 2014/0193623 A1<br>paragraphs [0021] to [0023], [0039] to [0053], [0166] to [0174]; table 6, particularly, example 31<br>& CN 103717332 A | 1–5 |

☒   Further documents are listed in the continuation of Box C.　　　　☐　See patent family annex.

| | |
|---|---|
| *   Special categories of cited documents:<br>"A"   document defining the general state of the art which is not considered    to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
|---|---|
| 12 October 2017 (12.10.17) | 24 October 2017 (24.10.17) |

| Name and mailing address of the ISA/<br>　　Japan Patent Office<br>　　3-4-3,Kasumigaseki,Chiyoda-ku,<br>　　Tokyo 100-8915,Japan | Authorized officer |
|---|---|
| | Telephone No. |

Form PCT/ISA/210 (second sheet) (January 2015)

30

**INTERNATIONAL SEARCH REPORT**

International application No.

PCT/JP2017/033962

C (Continuation).   DOCUMENTS CONSIDERED TO BE RELEVANT

| Category* | Citation of document, with indication, where appropriate, of the relevant passages | Relevant to claim No. |
|---|---|---|
| X | JP 2007-283479 A  (Sumitomo Electric Industries, Ltd.), 01 November 2007 (01.11.2007), paragraphs [0016] to [0017], [0054] to [0064], [0075] to [0078]; table 1, particularly, examples 18 to 19 (Family: none) | 1-5 |
| X | JP 2008-142800 A  (Sumitomo Electric Industries, Ltd.), 26 June 2008 (26.06.2008), paragraphs [0012] to [0013], [0027] to [0035], [0049] to [0052]; table 1, particularly, example 16 (Family: none) | 1-5 |
| P,A | JP 2017-159424 A  (Mitsubishi Materials Corp.), 14 September 2017 (14.09.2017), paragraphs [0014], [0053] to [0065]; table 14 (Family: none) | 1-5 |
| A | JP 2015-58503 A  (Mitsubishi Materials Corp.), 30 March 2015 (30.03.2015), paragraphs [0026], [0054], [0057]; table 11, particularly, Kind Types 21, 23, 26, 28 to 29 (Family: none) | 1-5 |
| A | JP 2011-11287 A  (Sumitomo Electric Industries, Ltd.), 20 January 2011 (20.01.2011), entire text; all drawings (Family: none) | 1-5 |

Form PCT/ISA/210 (continuation of second sheet) (January 2015)

**EP 3 527 309 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016199966 A
- WO 2015064241 A
- WO 2006070730 A